Europäisches Patentamt

European Patent Office

Office européen des brevets

(11) Numéro de publication: **0 278 193 B1**

# FASCICULE DE BREVET EUROPEEN

(45) Date de publication de fascicule du brevet: **10.06.92** (51) Int. Cl.⁵: **G01R 19/00**, G01R 19/18

(21) Numéro de dépôt: **87402940.8**

(22) Date de dépôt: **21.12.87**

(54) **Circuit de mesure de la composante continue du courant parcourant l'enroulement primaire du transformateur de sortie d'un onduleur.**

(30) Priorité: **09.01.87 FR 8700243**

(43) Date de publication de la demande:
**17.08.88 Bulletin 88/33**

(45) Mention de la délivrance du brevet:
**10.06.92 Bulletin 92/24**

(84) Etats contractants désignés:
**AT BE CH DE ES GB IT LI NL SE**

(56) Documents cités:
**DE-A- 3 040 753
GB-A- 2 143 958
US-A- 3 657 631**

(73) Titulaire: **MERLIN GERIN
Rue Henri Tarze
F-38050 Grenoble Cédex(FR)**

(72) Inventeur: **Moreau, Philippe
Merlin Gerin Sce. Brevets
F-38050 Grenoble Cédex(GB)**
Inventeur: **Fiorina, Jean-Noel
Merlin Gerin Sce. Brevets
F-38050 Grenoble Cédex(GB)**

(74) Mandataire: **Kern, Paul et al
Merlin Gerin Sce. Brevets 20, rue Henri Tarze
F-38050 Grenoble Cédex(FR)**

## Description

L'invention concerne un circuit de mesure de la composante continue du courant parcourant l'enroulement primaire du transformateur de sortie d'un onduleur.

Dans les onduleurs des convertisseurs de puissance, l'existence de courants continus parasites dans l'enroulement primaire du transformateur de sortie de l'onduleur pose des problèmes de saturation du transformateur.

Jusqu'ici, l'utilisation de transformateurs comportant un entrefer, et supportant en conséquence le passage d'une composante continue, a permis de négliger ce problème. L'utilisation de plus en plus fréquente de transformateurs sans entrefer le rend par contre plus aigu. Il est donc souhaitable d'éliminer cette composante continue et pour cela, il est nécessaire d'en avoir une mesure qui pourra être utilisée par le circuit de commande de l'onduleur pour réaliser un asservissement de cette composante à zéro.

La composante alternative, à la fréquence du réseau, ayant une grande amplitude par rapport à la composante continue, l'utilisation de filtres RC entraînerait un déphasage important qui déséquilibrerait la boucle de contre-réaction destinée à réaliser l'asservissement.

L'invention a pour but la réalisation d'un circuit de mesure, à la fois simple et efficace, n'introduisant pas de déphasage et permettant de fournir une réponse appropriée au problème posé.

Le circuit de mesure selon l'invention est caractérisé en ce qu'il comporte un dispositif de détection produisant un signal réprésentatif du courant parcourant l'enroulement, un intégrateur destiné à intégrer le signal détecté sur une période de la composante alternative du courant, le signal de sortie de l'intégrateur étant remis à zéro au début de chacune desdites périodes et étant appliqué un échantillonneur-bloqueur destiné à l'échantillonner juste avant sa remise à zéro, ledit échantillonneur-bloqueur étant destiné à fournir en sortie un signal représentatif de l'amplitude moyenne de la composante continue présente pendant la période précédente.

Ce circuit, s'il fonctionne correctement lorsque la charge du transformateur est constante ou varie lentement, ne permet pas de fournir une mesure correcte de la composante continue dans le cas où il y a des modifications brusques de la charge.

Pour résoudre ce second problème, dans le mode de réalisation préféré de l'invention, le signal de sortie de l'intégrateur est appliqué à l'échantillonneur-bloqueur par l'intermédiaire d'un étage intermédiaire comportant un amplificateur opérationnel dont l'entrée positive est reliée à la masse et dont l'entrée négative est reliée à la sortie de l'intégrateur par une première résistance et à l'entrée de l'échantillonneur-bloqueur par une seconde résistance, une troisième résistance étant disposée entre la sortie de l'amplificateur opérationnel et l'entrée de l'échantillonneur-bloqueur, de manière à limiter la variation maximale possible du signal de sortie du circuit de mesure pendant la période d'échantillonnage.

D'autres avantages et caractéristiques de l'invention ressortiront plus clairement de l'exposé qui va suivre de différents modes de réalisation de l'invention, donnés à titre d'exemples non limitatifs et représentés aux dessins annexés dans lesquels :

- la figure 1 représente, sous forme schématique, un circuit de mesure selon un premier mode de réalisation de l'invention ;
- la figure 2 représente les formes d'onde des signaux V1, V2 et V3 présents dans le circuit selon la figure 1 ;
- la figure 3 représente les formes d'onde des mêmes signaux obtenus avec le circuit selon la figure1, dans le cas d'un impact de charge ;
- la figure 4 représente également sous forme schématique, un circuit de mesure selon un second mode de réalisation de l'invention ;
- la figure 5 représente la forme d'onde du signal V5 présent dans le circuit de la figure 4 ;
- et la figure 6 représente, de manière très schématique, un onduleur comportant un circuit de mesure selon l'invention.

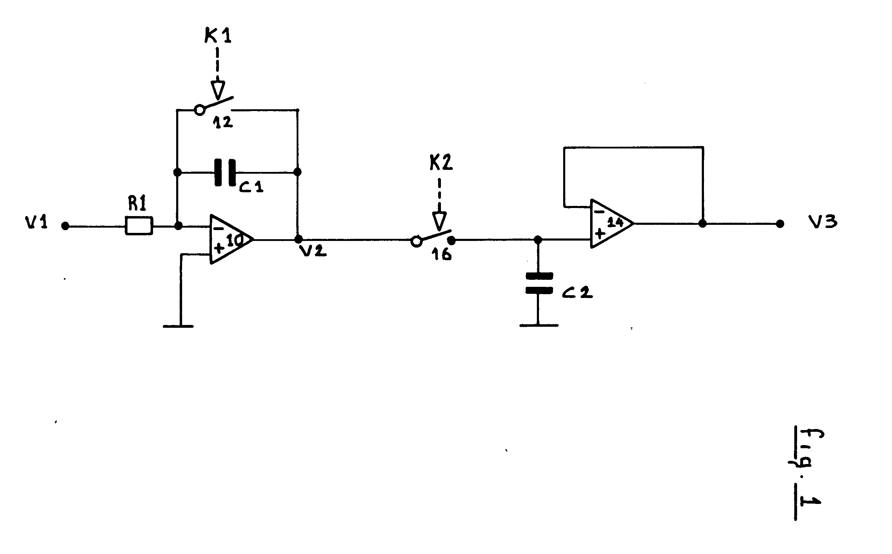

Le circuit de mesure représenté à la figure 1 comporte un premier amplificateur opérationnel 10 destiné à intégrer le signal d'entrée constitué par une tension V1 représentative d'un courant comportant une composante alternative sinusoïdale v et une composante continue Vo. La tension V1 est donc appliquée par l'intermédiaire d'une résistance R1 à l'entrée négative de l'amplificateur opérationnel 10, dont l'entrée positive est reliée à la masse. L'entrée négative de l'amplificateur est reliée à sa sortie par un condensateur C1. L'amplificateur constitue ainsi un intégrateur, la tension de sortie V2 étant donnée par

$$V2 = -\frac{1}{R1C1}\int V1\,dt$$

EP 0 278 193 B1

Selon l'invention, afin d'éliminer la composante alternative du signal d'entrée V1 et d'obtenir en sortie de l'intégrateur un signal proportionnel à la composante continue de ce signal, l'intégration a lieu sur une période T de la composante alternative. L'intégrateur est remis à zéro au moyen d'un interrupteur 12, normalement ouvert, disposé en parallèle avec le condensateur C1, qui est fermé un court instant au début de chaque période. Dans un mode préféré de réalisation, l'interrupteur, qui peut être constitué par tout interrupteur à semi-conducteur, est commandé par un signal K1 obtenu à partir d'un signal représentatif des passages à zéro du courant alternatif. Dans le cas où le circuit de mesure est utilisé dans un onduleur, un tel signal périodique est déjà disponible.

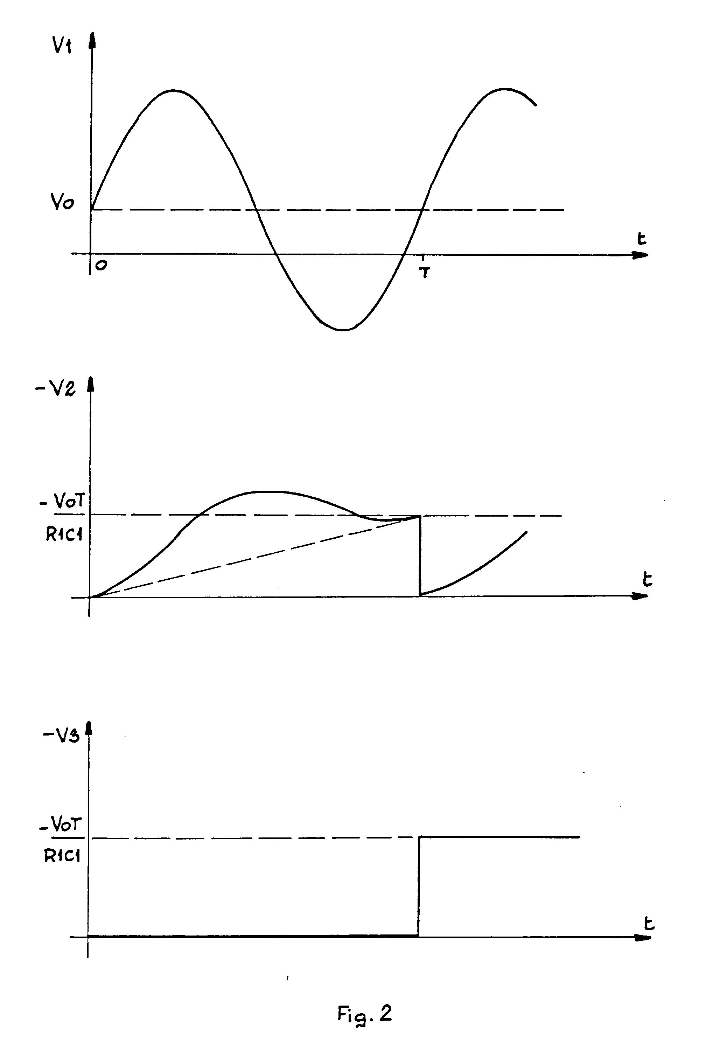

Les formes d'ondes des signaux V1 et V2 sont représentés à la figure 2. Pour un signal V1 de la forme V1 = Vo + v, Vo étant la composante continue et v la composante alternative, on obtient au bout d'un temps T correspondant à une période de la composante alternative v un signal :

$$V2 = - \frac{1}{R1C1} \int_0^T V1\ dt \qquad = - \frac{Vo}{R1C1} \cdot T \text{ pour } Vo = \text{constante}$$

V2 étant remis à zéro aux temps 0, T, 2T....

En pratique, le signal V1 comporte non seulement la composante continue Vo et la composante sinusoïdale v, mais également des harmoniques de cette dernière. Pour un signal v à la fréquence du réseau (50 Hz), il s'agit essentiellement o|'harmoniques à la fréquence 2 khz qui s'annulent pratiquement au cours de l'intégration sur la période T (20 ms pour une fréquence de réseau de 50 Hz). L'erreur maximale correspond à une demi-alternance de l'harmonique, a une amplitude très faible et peut être négligée.

Le signal de sortie de l'intégrateur est appliqué à un échantillonneur-bloqueur. Celui-ci est constitué par un amplificateur opérationnel 14 monté en étage suiveur, dont l'entrée positive est reliée par un interrupteur 16 à la sortie de l'intégrateur et par un condensateur C2 à la masse, et dont l'entrée négative est reliée à la sortie. L'interrupteur 16, normalement ouvert, est constitué par un interrupteur à semi-conducteur de type quelconque et est commandé par un signal K2 qui le ferme pendant un court instant, juste avant la remise à zéro de l'intégrateur, c'est-à-dire juste avant la fermeture de l'interrupteur 12 par le signal K1.

A titre d'exemple, pour une fréquence de réseau de 50 Hz, donc une période T de 20 ms, la durée de chacun des signaux de remise à zéro K1 et d'échantillonnage K2 est d'environ 150 $\mu s$.

Pendant la durée de la fermeture de l'interrupteur 16, ou durée d'échantillonnage, le signal V2 de sortie de l'intégrateur est donc appliqué au condensateur C2 qui conserve l'information jusqu'à la fermeture suivante de l'interrupteur, soit pendant une période T. Comme représenté à la figure 2, le signal V3 de sortie de l'échantillonneur-bloqueur est donc représentatif de la valeur moyenne de l'amplitude de la composante continue Vo du signal d'entrée pendant la période précédente.

Dans l'application envisagée, à savoir la mesure du courant continu parcourant l'enroulement primaire du transformateur de sortie d'un onduleur, ce décalage entre la valeur réelle instantanée et la valeur mesurée n'est pas gênant, car la constante de temps de saturation du transformateur est très grande par rapport à la période T sur laquelle se font l'intégration et l'échantillonnage.

Le circuit de mesure de la figure 1, s'il fonctionne correctement lorsque la charge du transformateur est constante ou varie lentement, ne permet pas de résoudre le problème posé dans le cas où il y a des modifications brusques de la charge du transformateur, par exemple lors d'une prise en charge.

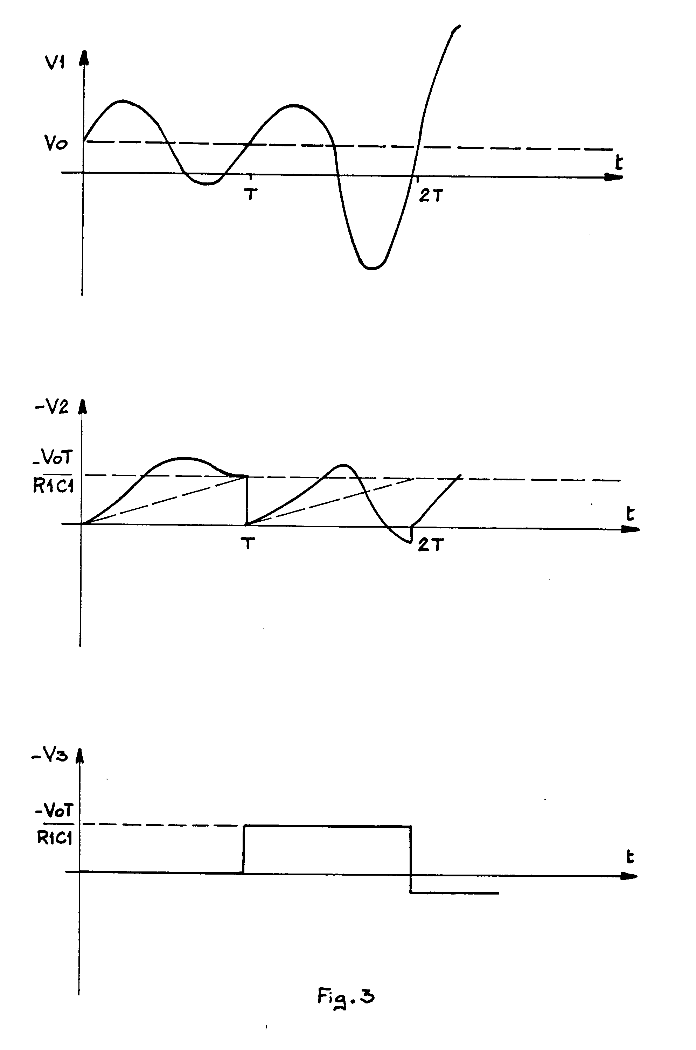

L'influence d'un impact de charge est illustrée à la figure 3, sur laquelle on a supposé constante la composante continue Vo.

La valeur du signal V3 à l'instant 2T ne correspond pas à une modification de la composante continue parasite, mais à une variation brusque de l'amplitude de la composante alternative pendant la période d'intégration, entre T et 2 T sur la figure. Si cet impact de charge est interprété comme une modification brusque de la composante continue et la valeur V3 obtenue utilisée pour réguler cette composante continue, cela conduit inévitablement à une perturbation du système.

Il est donc souhaitable de supprimer toute information qui peut être considérée comme aberrante. Comme cela a déjà été souligné précédemment, la constante de temps de saturation d'un transformateur est très grande vis-à-vis de la période T de mesure de la composante continue, de sorte que la suppression d'une information pendant une période n'est pas gênante en pratique. On pourrait fixer un seuil à partir duquel une mesure est considérée comme aberrante. Mais ce seuil, qui devrait être élevé dans certaines applications où la composante continue peut être importante, est difficile déterminer. La présente invention offre donc une autre solution à ce problème.

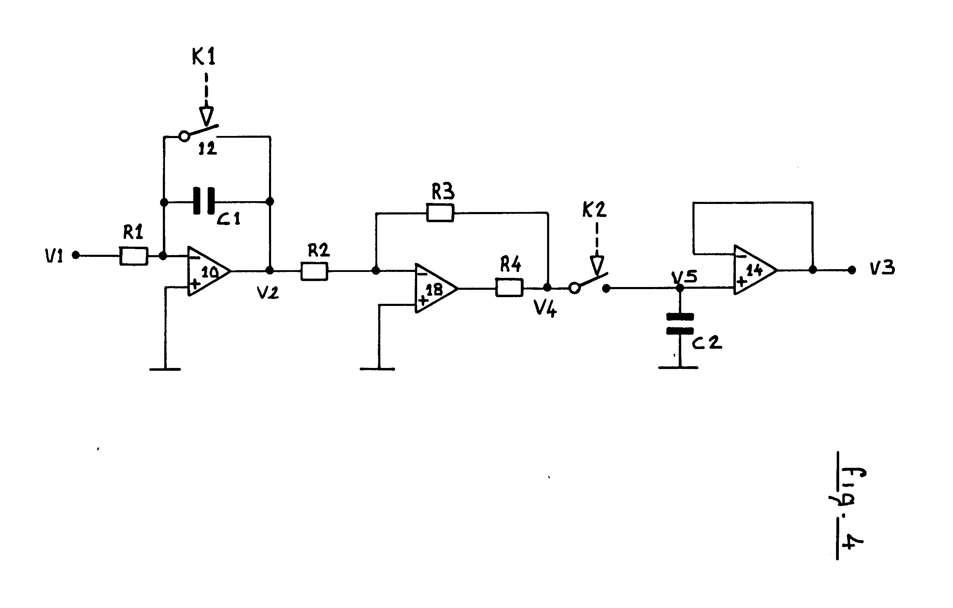

Dans le mode de réalisation préférentiel illustré à la figure 4, dans lequel les éléments identiques à

3

ceux du circuit de mesure selon la figure 1 sont désignés par les memes références, on intercale entre les étages intégrateur et échantillonneur-bloqueur un étage intermédiaire limitant les variations possibles de la tension appliquée à l'étage échantillonneur-bloqueur entre deux périodes. Cet étage intermédiaire est constitué par un amplificateur opérationnel 18 dont l'entrée positive est reliée à la masse et dont l'entrée négative est reliée, d'une part à la sortie de l'intégrateur par une résistance R2 et d'autre part à l'entrée de l'échantillonneur-bloqueur par une résistance R3. La sortie de l'amplificateur opérationnel 18 est, quant à elle, reliée à l'entrée de l'échantillonneur-bloqueur par une résistance R4, ce qui revient à augmenter artificiellement l'impédance de sortie de l'amplificateur opérationnel 18.

Lors de la fermeture de l'interrupteur 16, la tension V4 de sortie de l'étage intermédiaire prend la valeur de la tension V5 existant aux bornes du condensateur C2 de l'échantillonneur-bloqueur, cette tension V5 ne pouvant varier instantanément. Pour des résistances R2 et R3 de même valeur, c'est-à-dire un étage intermédiaire de gain égal à l'unité, lorsque la tension V4 de sortie est différente de la tension V2 d'entrée, l'amplificateur opérationnel 18 est en état de saturation et le condensateur C2 se charge ou se décharge, à travers la résistance R4, avec une constante de temps R4C2, la tension V5 aux bornes du condensateur tendant vers la tension de saturation ± Vsat de l'amplificateur 18. La constante de temps R4C2 est choisie de manière à être grande par rapport au temps$\Delta$TK2 (environ 150 $\mu$s) de fermeture de l'interrupteur 16. Pendant cette durée, la tension V5 ne peut augmenter ou diminuer, que d'une valeur prédéterminée

$$\Delta \text{ Vmax } = \text{Vsat.} \ \frac{\Delta TK2}{R4C2}$$

Ainsi, pendant la période d'échantillonnage durant laquelle l'interrupteur 16 est fermé, lorsque les tensions V5 et V4 atteignent la valeur de V2, c'est-à-dire lorsque la variation de tension demandée par l'intégrateur par rapport à la période précédente est inférieure à $\Delta$Vmax, l'amplificateur opérationnel n'est plus saturé et l'étage intermédiaire ne joue plus aucun rôle. Par contre, si la variation de tension demandée par l'intégrateur est supérieure à la valeur maximale $\Delta$Vmax, la variation effective de tension du signal V5 est limitée à cette valeur maximale, comme représenté sur la figure 5.

A titre d'exemple, si l'excursion maximale prévisible de la composante continue est de 150 mV, on choisit les valeurs R4 et C2, de manière à ce que la variation maximale de la tension V5 et donc de la tension V3, d'une période à l'autre soit limitée à 40 mV. Cela implique donc qu'il faudra 4 périodes au circuit de mesure pour rendre compte d'une telle excursion maximale. Ceci n'est pas gênant en pratique, car une telle variation s'effectue normalement lentement. Par contre, en cas d'impact de charge, l'augmentation de la tension V5, et donc de la tension V3, sera limitée à 40 mV, la valeur mesurée se restabilisant dès qu'il y a stabilisation de la charge, limitant ainsi l'influence de la mesure aberrante. Cet écart, limité à 40 mV, de la valeur mesurée par rapport à la valeur réelle de la composante continue, ne sera pas critique pour la régulation de la composante continue. Son influence sera en effet pratiquement nulle, en moyenne, sur une durée de 100 ms à 1 s.

Il est bien évident que l'étage intermédiaire n'a pas obligatoirement un gain égal l'unité, le rapport des résistances R2 et R3 devant alors être pris en compte pour la détermination de la variation maximale autorisée.

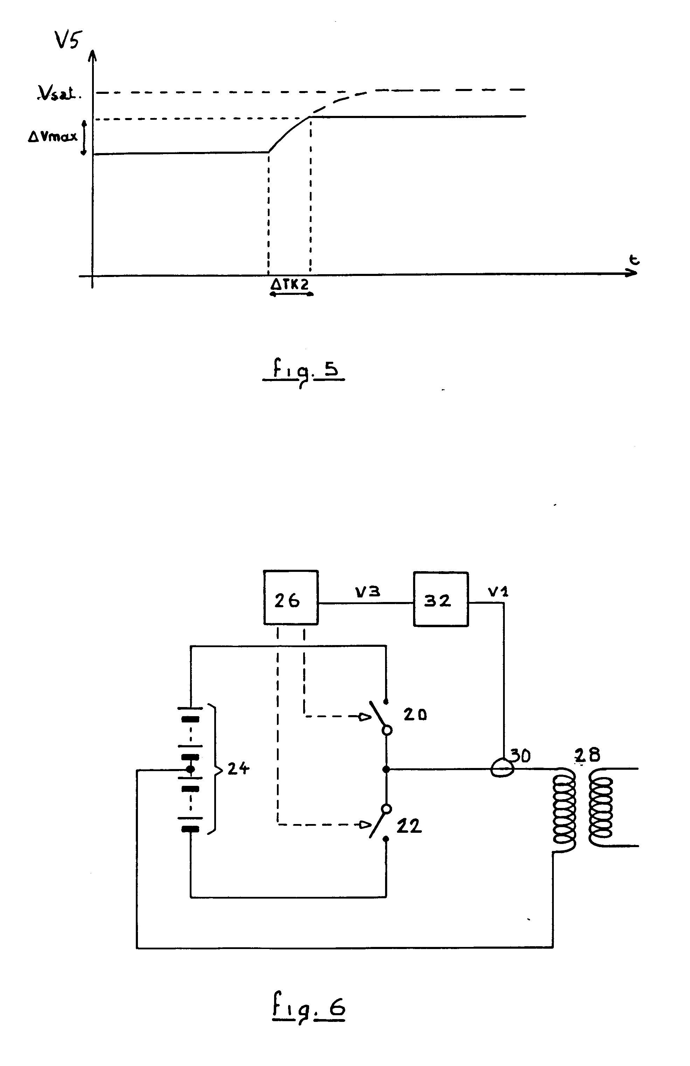

La figure 6 illustre de manière schématique un onduleur comportant un circuit de mesure selon l'invention. Dans le mode de réalisation représenté, à titre d'exemple, il s'agit d'un onduleur du type comportant deux interrupteurs commandés en série et une source à point milieu. Les deux interrupteurs commandés 20, 22, sont disposés en série aux bornes de la source 24 de tension continue, les interrupteurs étant commandés alternativement par un circuit de commande 26. De manière connue, ces interrupteurs sont des interrupteurs bidirectionnels en courant réalisés à l'aide d'un composant connecté en antiparallèle avec une diode, ce composant pouvant par exemple être constitué par un thyristor, un transistor bipolaire, un transistor MOS, etc... L'enroulement primaire d'un transformateur de sortie 28 est connecté entre le point commun aux deux interrupteurs et le point milieu de la source 24.

La structure et le fonctionnement d'un onduleur de ce type sont bien connus des spécialistes et ne seront pas décrits plus en détail. Ainsi que cela a déjà été mentionné, il se pose des problèmes de saturation lorsque l'enroulement primaire du transformateur de sortie est parcouru par un courant comportant une composante continue, surtout dans le cas où le transformateur utilisé ne comporte pas d'entrefer.

L'invention permet de mesurer la composante continue du courant circulant dans le primaire du transformateur. Le courant, constitué par la superposition d'une composante alternative et d'une composante continue, est détecté au moyen d'un capteur 30, qui est par exemple un capteur à effet Hall, qui fournit un signal de tension (V1) représentatif du courant qui est appliqué à un circuit 32 de mesure du type de celui représenté sur la figure 4. Le signal V3 de sortie du circuit 32 de mesure est appliqué au circuit de commande 26 qui modifie en conséquence les durées de fermeture des interrupteurs, de manière à tendre à annuler la composante continue du courant circulant dans le transformateur. Ainsi, lorsqu'une composante continue positive est mesurée, le circuit de commande 26 modifiera les durées respectives de fermeture des interrupteurs 20 et 22, de manière à ce que l'interrupteur 20, relié à la borne positive de la batterie 24 soit conducteur moins longtemps. Les moyens nécessaires à la mise en oeuvre d'un tel asservissement sont bien connus des spécialistes et ne seront donc pas décrits plus en détail.

Il est bien évident que le circuit de mesure selon l'invention est utilisable non seulement pour le transformateur de sortie d'un onduleur du type représenté à la figure 6, mais pour tout type d'onduleur, qu'il s'agisse d'un montage à deux interrupteurs, en série ou en parallèle avec un transformateur à point milieu, ou d'un montage en pont à quatre interrupteurs, et qu'il s'agisse d'un onduleur monophasé ou triphasé. Dans ce dernier cas, on utilise seulement deux circuits de mesure selon l'invention pour asservir deux des phases, la troisième phase s'asservissant alors d'elle-même.

**Revendications**

1. Circuit de mesure de la composante continue du courant parcourant l'enroulement primaire du transformateur de sortie (28) d'un onduleur, caractérisé en ce que ledit circuit comporte un dispositif (30) de détection produisant un signal (V1) représentatif du courant parcourant ledit enroulement, un intégrateur (10, 12, R1, C1) destiné à intégrer ledit signal (V1) détecté sur une période de la composante alternative du courant, le signal de sortie (V2) de l'intégrateur (10, 12, R1, C1) étant remis à zéro (K1) au début de chacune desdites périodes et étant appliqué à un échantillonneur-bloqueur (16, 14, C2) destiné à l'échantillonner (K2) juste avant sa remise à zéro, ledit échantillonneur-bloqueur (16, 14, C2) étant destiné à fournir en sortie un signal (V3) représentatif de l'amplitude moyenne de la composante continue présente pendant la période précédente.

2. Circuit selon la revendication 1, caractérisé en ce que le signal (V2) de sortie de l'intégrateur (10, 12, R1, C1) est appliqué à l'échantillonneur-bloqueur (16, 14, C2) par l'intermédiaire d'un étage intermédiaire comportant un premier amplificateur opérationnel (18) dont l'entrée positive est reliée à la masse et dont l'entrée négative est reliée à la sortie de l'intégrateur (10, 12, R1, C1) par une première résistance (R2) et à l'entrée de l'échantillonneur-bloqueur (16, 14, C2) par une seconde résistance (R3), une troisième résistance (R4) étant disposée entre la sortie du premier amplificateur opérationnel (18) et l'entrée de l'échantillonneur-bloqueur, (16, 14, C2) de manière à limiter la variation maximale possible du signal (V3) de sortie du circuit de mesure pendant la période d'échantillonnage.

3. Circuit selon l'une des revendications 1 et 2, caractérisé en ce que l'intégrateur est constitué par un second amplificateur opérationnel (10) dont l'entrée positive est reliée à la masse et dont l'entrée négative est reliée par un premier condensateur (C1) à la sortie, un premier interrupteur (12), normalement ouvert, étant disposé en parallèle sur le premier condensateur (C1) et étant fermé un court instant, sous la commande d'un signal (K1), au début de chaque période de la composante alternative du courant, de manière à remettre à zéro l'intégrateur, le signal représentatif du courant parcourant le transformateur de sortie (28) de l'onduleur étant constitué par une tension (V1) et appliqué l'entrée négative du second amplificateur opérationnel (10) par l'intermédiaire d'une quatrième résistance (R1).

4. Circuit selon la revendication 3, caractérisé en ce que le signal (K1) de commande du premier interrupteur (12) est obtenu à partir d'un signal représentatif du passage à zéro de la composante alternative du courant.

5. Circuit selon l'une quelconque des revendications 1 à 4, caractérisé en ce que l'échantillonneur-bloqueur est constitué par un troisième amplificateur opérationnel (14) dont l'entrée négative est reliée à la sortie et dont l'entrée positive est reliée par l'intermédiaire d'un second condensateur (C2) à la masse et par l'intermédiaire d'un second interrupteur (16), normalement ouvert, à l'entrée de l'échantillonneur-bloqueur, le second interrupteur (16) étant fermé un court instant, sous la commande d'un signal (K2), juste avant la remise à zéro de l'intégrateur.

6. Circuit selon la revendication 5, caractérisé en ce que le signal (K2) de commande du second

EP 0 278 193 B1

interrupteur est obtenu à partir d'un signal représentatif du passage à zéro de la composante alternative du courant.

**Claims**

1. A measuring circuit of the D.C. component of the current flowing through the primary winding of the output transformer of an inverter, characterized in that said circuit comprises a detection device (30) producing a signal (V1) representative of the current flowing through said winding, an integrator (10, 12, R1, C1) designed to integrate said signal (V1) detected on a period of the A.C. component of the current, the integrator output signal (V2) being reset to zero (K1) at the beginning of each of said periods and being applied to a sample and hold stage (16, 14, C2) designed to sample it (K2) just before it is reset, said sample and hold stage (16, 14, C2) being designed to supply on output a signal (V3) representative of the mean amplitude of the D.C. component present during the previous period.

2. The circuit according to claim 1, characterized in that the output signal (V2) of the integrator (10, 12, R1, C1) is applied to the sample and hold stage (16, 14, C2) via an intermediate stage comprising a first operational amplifier (18) whose positive input is grounded and whose negative input is connected to the output of the integrator (10, 12, R1, C1) by a first resistor (R2) and to the input of the sample and hold stage (16, 14, C2) by a second resistor (R3), a third resistor (R4) being arranged between the output of the first operational amplifier (18) and the input of the sample and hold stage (16, 14, C2), in such a way as to limit the maximum possible variation of the measuring circuit output signal (V3) during the sampling period.

3. The circuit according to one of the claims 1 and 2, characterized in that the integrator is constituted by a second operational amplifier (10) whose positive input is earthed and whose negative input is connected to the output by a first capacitor (C1), a first normally open switch (12) being fitted in parallel on the first capacitor (C1) and being closed for a short time, under the control of a signal (K1), at the beginning of each period of the A.C. component of the current, so as to reset the integrator, the signal representative of the current flowing through the inverter output transformer (28) being constituted by a voltage (V1) and applied to the negative input of the second operational amplifier (10) by means of a fourth resistor (R1).

4. The circuit according to claim 3, characterized in that the control signal (K1) of the first switch (12) is obtained from a signal reppresentative of the A.C. component of the current passing zero.

5. The circuit according to any one of the claims 1 to 4, characterized in that the sample and hold stage is constituted by a third operational amplifier (14) whose negative input is connected to the output and whose positive input is connected via a second capacitor (C2) to the ground and via a second normally open switch (16) to the sample and hold stage input, the second switch (16) being closed for a short time, under the control of a signal (K2), just before the integrator is reset.

6. The circuit according to claim 5, characterized in that the control signal (K2) of the second switch is obtained from a signal representative of the A.C. component of the current passing zero.

**Patentansprüche**

1. Meßschaltung zur Erfassung des Gleichstromanteils in der Primärwicklung des Ausgangstransformators (28) eines Wechselrichters, dadurch gekennzeichnet, daß die genannte Schaltung aus einem Detektor (30), der ein dem Strom in der genannten Wicklung entsprechendes Signal (V1) erzeugt, sowie einem Integrator (10, 12, R1, C1) besteht, der zur Aufintegration des über eine Periode des Wechselstromanteils erfaßten genannten Signals (V1) dient, wobei das Ausgangssignal (V2) des Integrators (10, 12, R1, C1) zu Beginn jeder Periode rückgesetzt (K1) und einer Abtast-Blockier-Schaltung (16, 14, C2) zur Abtastung (K2) des Signals unmittelbar vor dem Rücksetzen zugeführt wird und die genannte Abtast-Blockier-Schaltung (16, 14, C2) dazu dient, ein Ausgangssignal (V3) zu liefern, das der mittleren Amplitude des Gleichstromanteils der vorausgehenden Periode entspricht.

2. Schaltungsanordnung nach Anspruch 1, dadurch gekennzeichnet, daß das Ausgangssignal (V2) des Integrators (10, 12, R1, C1) der Abtast-Blockier-Schaltung (16, 14, C2) über eine Zwischenstufe mit

6

einem ersten Operationsverstärker (18) zugeführt wird, dessen positiver Eingang an Masse liegt und dessen negativer Eingang über einen ersten Widerstand (R2) mit dem Ausgang des Integrators (10, 12, R1, C1) und über einen zweiten Widerstand (R3) mit dem Eingang der Abtast-BlockierSchaltung (16, 14, C2) verbunden ist, wobei ein dritter Widerstand (R4) zwischen dem Ausgang des ersten Operationsverstärkers (18) und dem Eingang der Abtast-Blockier-Schaltung (16, 14, C2) liegt, derart daß die maximale Änderung des Ausgangssignals (V3) der Meßschaltung während der Abtastdauer begrenzt wird.

3. Schaltungsanordnung nach Anspruch 1 oder 2, dadurch gekennzeichnet, daß der Integrator aus einem zweiten Operationsverstärker (10) besteht, dessen positiver Eingang an Masse liegt und dessen negativer Eingang über einen ersten Kondensator (C1) mit dem Ausgang verbunden ist, und daß ein parallel zum ersten Kondensator (C1) liegender erster Schließkontakt (12) zu Beginn jeder Periode des Wechselstromanteils durch ein Steuersignal (K1) kurzzeitig geschlossen wird und so ein Rücksetzen des Integrators bewirkt, wobei das dem Strom im Ausgangstransformator (28) des Wechselrichters entsprechende Signal aus einer Spannung (V1) besteht und dem negativen Eingang des zweiten Operationsverstärkers (10) über einen vierten Widerstand (R1) zugeführt wird.

4. Schaltungsanordnung nach Anspruch 3, dadurch gekennzeichnet, daß das Steuersignal (K1) für den ersten Schließkontakt (12) aus einem dem Nulldurchgang des Wechselstromanteils entsprechenden Signal abgeleitet wird.

5. Schaltungsanordnung nach einem der Ansprüche 1 bis 4, dadurch gekennzeichnet, daß die Abtast-Blockier-Schaltung aus einem dritten Operationsverstärker (14) besteht, dessen negativer Eingang mit dem Ausgang und dessen positiver Eingang über einen zweiten Kondensator (C2) mit Masse sowie über einen zweiten Schließkontakt (16) mit dem Eingang der AbtastBlockier-Schaltung verbunden ist, wobei der zweite Schließkontakt (16) durch ein Steuersignal (K2) unmittelbar vor dem Rücksetzen des Integrators kurzzeitig geschlossen wird.

6. Schaltungsanordnung nach Anspruch 5, dadurch gekennzeichnet, daß das Steuersignal (K2) für den zweiten Schließkontakt aus einem dem Nulldurchgang des Wechselstromanteils entsprechenden Signal abgeleitet wird.

fig. 1

Fig. 2

Fig.3

fig. 4

$$\underline{fig. 5}$$

$$\underline{fig. 6}$$